# EUROPÄISCHE PATENTSCHRIFT

(11) **EP 2 463 962 B1**
(45) Veröffentlichungstag und Bekanntmachung des Hinweises auf die Patenterteilung: **30.06.2021**
(21) Anmeldenummer: 11188256.9
(22) Anmeldetag: 08.11.2011
(51) Int. Cl.: H01R 12/58, H01R 4/24, H05K 3/32, H01R 12/73, H01R 9/22

(54) **Kontaktelement, Verbindungssystem und Verfahren zum elektrischen Verbinden eines Kontaktdrahtes mit einer Leiterplatte**
Contact element, connecting system and method for electrically connecting a contact wire with a conductor board
Elément de contact, système de connexion et procédé de connexion électrique d'un fil conducteur avec une plaquette

(30) Priorität: 13.12.2010 DE 102010062927
(43) Veröffentlichungstag der Anmeldung: 13.06.2012
(73) Patentinhaber: Robert Bosch GmbH, 70442 Stuttgart (DE)
(72) Erfinder: Kloetzig, Rene, 72762 Reutlingen (DE); Dillmann, Adolf, 72525 Muensingen (DE); Moessner, Joerg, 72768 Reutlingen (DE); Huehner, Stefan, 72127 Kusterdingen (DE)

(56) Entgegenhaltungen:
- DE-A1- 10 249 683
- DE-A1-102009 026 816
- DE-B3-102004 050 715
- DE-C2- 4 332 534
- DE-U1-202009 009 933
- FR-A1- 2 828 985
- US-A1- 2002 166 690

## Beschreibung

### Stand der Technik

Die Erfindung betrifft ein Kontaktelement, insbesondere ein elektrisches Kontaktelement zum Verbinden eines Kontaktdrahtes mit einer Leiterplatte. Das Kontaktelement weist einen Stift auf, welcher ausgebildet ist, in die Leiterplatte, insbesondere einen Durchbruch in der Leiterplatte eingepresst zu werden. Das Kontaktelement weist auch eine Drahtaufnahme auf, welche ausgebildet ist, einen Längsabschnitt des Drahtes während eines Einführens in die Drahtaufnahme einschneidend und/oder einpressend zu kontaktieren und insbesondere federnd festzuhalten.

Aus der DE 43 32 534 C2 ist ein Bandkabelverbinder zum Kontaktieren einer Leiterplatte bekannt, wobei mit dem Kontaktträger verankerte Kontaktelemente Schneidklemmzonen zum Aufnehmen von elektrischen Leitungen des Bandkabels aufweisen, wobei die Kontaktelemente jeweils zum Verbinden mit einer Leiterplatte einen Einpressstiel aufweisen.

Aus der FR2828985A1 ist eine Anordnung bekannt, bei welcher eine Leiterplatte innerhalb einer Umhäusung durch ein Kontaktelement kontaktiert ist. Das Kontaktelement hat einen stiftförmigen Teilabschnitt, welcher ein elektrisches Bauelemt kontaktiert, welches außerhalb der Umhäusung angeordnet ist.

Die Offenlegungsschrift DE102009026816 A offenbart ein Anschlusselement zur elektrischen Verbindung von zwei Komponenten mit einem ersten elektrischen Kontaktelement zur elektrischen Kontaktierung einer ersten Komponente und einem zweiten elektrischen Kontaktelement zur elektrischen Kontaktierung einer zweiten Komponente und mindestens einem Toleranzausgleichselement. Dabei weisen ein Einpressabschnitt und das Schneidklemmelement zueinander unterschiedliche Materialdiche auf.

### Offenbarung der Erfindung

Erfindungsgemäß ist die Drahtaufnahme ausgebildet, den Kontaktdraht entlang einer Querachse aufzunehmen und zu kontaktieren, die mit wenigstens einer Querkomponente oder quer zu einer Stiftlängsachse des Stifts verläuft.

Dadurch kann vorteilhaft eine platzsparende Anordnung zwischen dem Kontaktdraht, insbesondere einem Stanzgitter, in dem der Kontaktdraht mittels Stanzen ausgebildet ist, mit der Leiterplatte platzsparend verbunden werden. Weiter vorteilhaft kann zum pressenden Verbinden der Drahtaufnahme mit dem Drahtabschnitt ein flach ausgebildetes Werkzeug eingesetzt werden.

Ferner weist ein elektrisch leitfähiger Teil des Kontaktelements wenigstens zwei Kontaktabschnitte mit zueinander verschiedenen Materialeigenschaften auf. Die Materialeigenschaft ist beispielsweise eine Steifigkeit, insbesondere ein Elastizitätsmodul oder eine Härte, insbesondere eine Mohs-Härte.

Die wenigstens zwei Kontaktabschnitte können beispielsweise mittels Elektronenstrahlschweißen miteinander verbunden sein. Weiter bevorzugt weisen die wenigstens zwei zueinander verschiedenen Kontaktabschnitte zueinander verschiedene Dicken, insbesondere Blechdicken auf.

Mittels der zueinander verschiedenen Materialeigenschaften kann vorteilhaft jeder Kontaktbereich eine für seine Kontaktierungsart optimale Materialeigenschaft aufweisen. Vorteilhaft weist beispielsweise der Stift eine größere Steifigkeit auf, als der Schneid-Klemm-Bereich, in dem die Drahtaufnahme ausgebildet ist.

Zusätzlich weist das Kontaktelement einen den Stift umfassenden Kontaktabschnitt auf, und einen weiteren Kontaktabschnitt, der mit dem den Stift umfassenden Kontaktabschnitt verbunden ist. Der weitere Kontaktabschnitt umfasst die Drahtaufnahme, wobei der den Stift umfassende Kontaktabschnitt aus einem härteren und/oder steiferen Material gebildet ist, als der die Drahtaufnahme umfassende Kontaktabschnitt.

In einer bevorzugten Ausführungsform des Kontaktelements ist zwischen der Drahtaufnahme und dem Stift ein elektrisch leitfähiger Entlastungsbereich gebildet, sodass eine Bewegung des Stiftes vermindert auf die Drahtaufnahme übertragen werden kann.

Durch den Entlastungsbereich kann vorteilhaft eine Vibration oder eine Bewegung des Stiftes, insbesondere übertragen durch die mit dem Stift verbundene Leiterplatte, vorteilhaft nicht oder nur vermindert auf die Drahtaufnahme und eine von der Drahtaufnahme erzeugte Schneid-Klemm-Verbindung übertragen werden. Die Schneid-Klemm-Verbindung ist so vorteilhaft vor Bewegungen oder Erschütterungen geschützt, welche die Verbindung zwischen der Drahtaufnahme und dem Längsabschnitt des Kontaktdrahtes lösen können.

In einer vorteilhaften Ausführungsform ist der Entlastungsbereich durch wenigstens eine elektrisch leitfähige Mäanderschleife gebildet. Weiter bevorzugt ist der Entlastungsbereich durch wenigstens zwei Mäanderschleifen gebildet, welche sich in einer Ebene des Kontaktelements in zueinander entgegengesetzte Richtungen erstrecken.

Das Kontaktelement ist bevorzugt flach ausgebildet. Das Kontaktelement ist beispielsweise aus einem Blech, insbesondere einem Kupferblech gestanzt. Während des Stanzens erhält der Stift einen quadratischen oder rechteckigen Querschnitt.

Der Stift kann vorteilhaft auf einem Längsabschnitt einen von dem rechteckigen oder quadratischen Querschnitt verschiedenen Querschnitt aufweisen. Beispielsweise weist der Stift auf einem Längsabschnitt einen sternförmigen Querschnitt auf. Dazu kann der Stift beispielsweise nach einem Stanzvorgang zum Herstellen des Kontaktelements, insbesondere einer Grundform des Kontaktelementes, mittels zweier Pressbacken die Sternform im Querschnitt erhalten.

Durch die Sternform des Stiftquerschnitts kann der Stift vorteilhaft mit jeder Sternzacke des Sterns eine Leiterbahn, beispielsweise Kupfer, der Leiterplatte schneidend während des Eingepresstwerdens in die Leiterplatte kontaktieren.

In einer bevorzugten Ausführungsform des Kontaktelements ist das Kontaktelement wenigstens abschnittsweise in einen elektrisch isolierenden Körper eingebettet. Der elektrisch isolierende Körper ist beispielsweise aus Kunststoff gebildet. Der Kunststoff ist beispielsweise Polyester, Polybutylenterephtalat, Polyethylen, Polypropylen, Polycarbonat oder Polyacryl.

Das Kontaktelement kann beispielsweise mittels eines Mold-Prozesses oder mittels eines Stitch-Verfahrens in den elektrisch isolierenden Körper eingebettet sein. Bei einem Mold-Prozess wird der elektrisch isolierende Körper um das Kontaktelement gegossen oder gespritzt. Bei einem Stitch-Verfahren wird das Kontaktelement abschnittsweise in eine Öffnung des Körpers eingepresst.

In einer bevorzugten Ausführungsform sind die Kontaktabschnitte jeweils aus einem Blech gebildet, wobei der den Stift umfassende Kontaktabschnitt aus einem dünneren Blech gebildet ist, als der die Drahtaufnahme umfassende Kontaktabschnitt. So kann vorteilhaft mittels des Stiftes ein in der Leiterplatte gebildeter Durchbruch kontaktiert werden, welcher einen kleineren Durchmesser aufweist, als eine Blechdicke, die den Längsabschnitt des Kontaktdrahtes kontaktiert.

Beispielsweise beträgt die Blechdicke im Bereich des Stiftes weniger oder gleich 0,6 Millimeter, die Blechdicke im Bereich der Drahtaufnahme wenigstens 0,8 Millimeter, oder genau 0,8 Millimeter.

Die Erfindung betrifft auch eine Kontaktreihe umfassend wenigstens ein Kontaktelement gemäß der vorgeschriebenen Art. Die Kontaktreihe weist wenigstens zwei oder mehrere Kontaktelemente auf, welche jeweils wenigstens abschnittsweise und gemeinsam in einen elektrisch isolierenden Körper eingebettet sind. Vorzugsweise weisen die Drahtaufnahmen der Kontaktelemente jeweils in eine gemeinsame Richtung. So kann die Kontaktreihe vorteilhaft mittels eines einzigen Pressvorgangs mit einem Gegenkontakt umfassend eine zur Anzahl der Kontaktelemente entsprechende Zahl von Gegenkontakten verbunden werden. Durch die gemeinsame Ausrichtung können die Kontaktelemente so beispielsweise mit einem Stanzgitter verbunden werden, wobei das Stanzgitter entsprechend angeordnete Kontaktdrähte aufweist.

Vorteilhaft kann so ein Verbindungssystem gebildet sein, wobei das Verbindungssystem wenigstens ein Kontaktelement und wenigstens einen Gegenkontakt aufweist. Bevorzugt weist das Verbindungssystem eine Kontaktreihe und eine Gegenkontaktreihe mit zu den Kontaktelementen der Kontaktreihe entsprechenden Gegenkontakten auf. Die Gegenkontakte können vorteilhaft gemeinsam in einen elektrisch isolierenden Körper eingebettet sein und so die Gegenkontaktreihe bilden.

Bevorzugt ist der Gegenkontakt in einer flachen Erstreckung als flache, insbesondere eckige Acht ausgebildet und weist den Kontaktdraht auf.

Bei einem Verfahren zum Verbinden wenigstens eines Kontaktdrahtes mit einer Leiterplatte wird der Kontaktdraht auf einem Längsabschnitt einschneidend und/oder einpressend von einem elektrisch leitfähigen Kontaktelement kontaktiert und wird von einer Drahtaufnahme auf dem Längsabschnitt wenigstens teilweise umschlossen. Bei dem Verfahren wird das Kontaktelement mit einem insbesondere stiftförmigen Endabschnitt in einen Durchbruch einer Leiterplatte eingeführt und die Leiterplatte dort elektrisch kontaktiert.

Bevorzugt wird der Längsabschnitt des Kontaktdrahtes in einer Richtung von der Drahtaufnahme aufgenommen und kontaktiert, die mit wenigstens einer Querkomponente oder quer zu einer Richtung verläuft, in die der insbesondere stiftförmige Endabschnitt in den Durchbruch eingeführt wird.

In einer bevorzugten Ausführungsform des Verfahrens wird das Kontaktelement von einem Presskopf berührt und pressend mit dem Längsabschnitt des Kontaktdrahtes zum Herstellen des elektrischen Kontaktes verbunden.

Bevorzugt ist der Presskopf durch einen Teil eines Bauelements einer Vorrichtung gebildet, die das Kontaktelement umfasst. Dadurch kann vorteilhaft ein Fertigungsschritt eingespart werden.
Figur 1 zeigt schematisch ein Ausführungsbeispiel für ein Kontaktelement zum elektrischen Verbinden einer Leiterplatte mit einem Kontaktdraht;
Figur 2 zeigt schematisch ein Ausführungsbeispiel für eine Kontaktreihe umfassend mehrere in Figur 1 dargestellte Kontaktelemente, welche mittels in eines isolierenden Körpers miteinander verbunden sind;
Figur 3 zeigt schematisch ein Ausführungsbeispiel für eine Gegenkontaktreihe mit Gegenkontakten, welche jeweils zum Verbinden mit einem Kontaktelement der in Figur 2 dargestellten Kontaktreihe ausgebildet sind und mittels eines isolierenden Körpers miteinander verbunden sind.

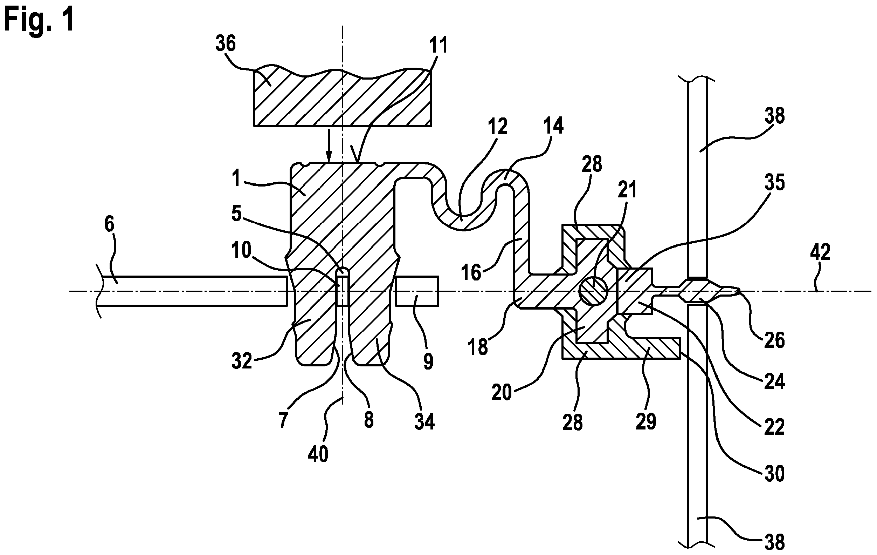

Figur 1 zeigt schematisch ein Ausführungsbeispiel für ein Kontaktelement 1. Das Kontaktelement 1 ist in diesem Ausführungsbeispiel mit einer Leiterplatte 38 und mit einem Gegenkontakt 9 verbunden, sodass der Gegenkontakt 9 über das Kontaktelement 1 mit der Leiterplatte 38 elektrisch verbunden ist. Die Leiterplatte 38 weist einen Durchbruch auf, in welchen ein Stiftabschnitt 22 des Kontaktelements eingeführt ist und die Leiterplatte 38 im Bereich des Durchbruchs elektrisch kontaktiert.

Das Kontaktelement 1 ist in diesem Ausführungsbeispiel flach ausgebildet und dazu aus Blech gestanzt. Das Blech ist beispielsweise Kupferblech. Das Kontaktelement 1 weist entlang einer Längsachse 42 einen Schneid-Klemm-Kontakt auf, welcher durch einen Bereich des Kontaktelements 1 gebildet ist, der eine rechteckförmige Großform aufweist.

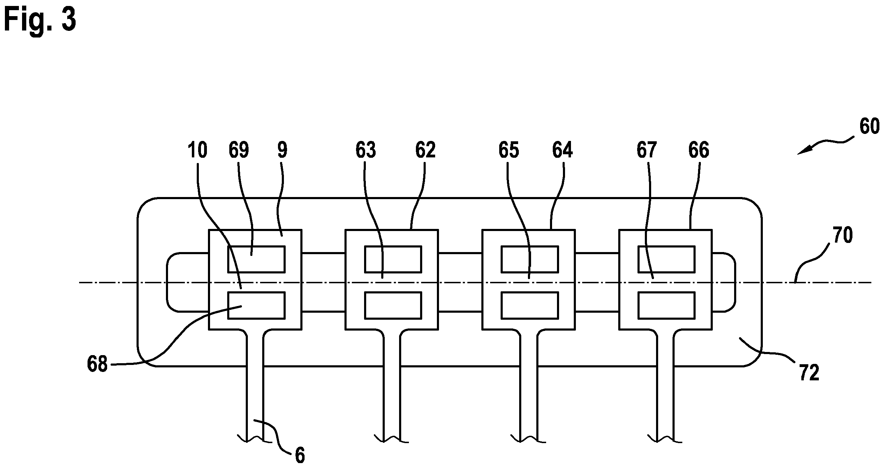

Das Kontaktelement 1 weist im Bereich eines Endes eine Drahtaufnahme 5 auf, welche in diesem Ausführungsbeispiel durch eine U-förmige Ausnehmung gebildet ist. Die Drahtaufnahme 5 weist eine Schneide 7 und eine Schneide 8 auf, welche jeweils durch einen Schenkel der U-Form gebildet sind. Das Kontaktelement 1 weist einen Endabschnitt 32 und einen Endabschnitt 34 auf, welche jeweils den zuvor erwähnten Drahtaufnahme 5 zwischeneinander einschließen. Der so gebildete Schneid-Klemm-Kontakt ist in diesem Ausführungsbeispiel mit einem Gegenkontakt 9 verbunden, wobei der Gegenkontakt durch ein Stanzgitter aus Kupfer gebildet ist, welches in einer Aufsicht auf eine flache Erstreckung eine eckige Acht-Form aufweist. Der Gegenkontakt 9 ist in Figur 3 in der Aufsicht dargestellt.

Das Kontaktelement 1 weist auch eine Pressfläche 11 auf, wobei die Pressfläche 11 durch eine Seite der zuvor beschriebenen Rechteckform des Schneid-Klemm-Kontakts und durch eine quer zu der Seite verlaufende Dickenabmessung des Kontaktelements 1 im Bereich des Schneid-Klemm-Kontaktes gebildet ist. Die Seite der Pressfläche 11 erstreckt sich parallel zur Kontaktelementlängsachse 42. So kann der Schneid-Klemm-Kontakt des Kontaktelements 1 mittels eines mit wenigstens einer Seite flach ausgebildeten Objekts 36, welches beispielsweise durch ein Bauteil einer Vorrichtung gebildet ist, die sowohl das Kontaktelement 1 als auch das Bauteil 36 aufweist, von dem Objekt 36 an der Pressfläche 11 berührt und mit dem Gegenkontakt 9 pressend verbunden werden. Dabei wird ein Drahtabschnitt 10 des Gegenkontakts, welcher beispielsweise einen mittleren Balken, der in Figur 3 in der Aufsicht gezeigten eckigen Acht bildet, von der Drahtaufnahme 5 aufgenommen und durch Pressen und/oder Einschneiden mittels der Schneiden 7 und 8 elektrisch kontaktiert und federnd festgehalten.

Das Kontaktelement 1 weist einen Drahtabschnitt auf, welcher im Bereich der Pressfläche 11 mit dem zuvor beschriebenen rechteckförmigen Bereich verbunden oder an diesen angeformt ist. Der Drahtabschnitt erstreckt sich beginnend von dem rechteckförmigen Bereich parallel zur Längsachse 42 und nimmt in einem weiteren Verlauf eine Mäanderform ein. Die Mäanderform weist eine Mäanderschleife 12 auf, an welche sich eine in entgegengesetzt zur Mäanderschleife 12 mäandrierende Mäanderschleife 14 erstreckt. Im weiteren Verlauf geht der Drahtabschnitt von der Mäanderschleife 14 ausgehend in einen Drahtabschnitt 16 über, welcher sich parallel zu einer Querachse 40 des Kontaktelements 1 erstreckt. Die Querachse 40 des Kontaktelements 1 verläuft senkrecht zur Längsachse 42 des Kontaktelements 1.

An dem Drahtabschnitt 16 schließt ein Längsabschnitt 18 des Kontaktelements 1 an, welcher rechtwinklig von dem Drahtabschnitt 16 abzweigt und von der Drahtaufnahme 5, welche sich entlang der Querachse 40 erstreckt, abweist.

An den Längsabschnitt 18 schließt ein Längsabschnitt 20 des Kontaktelements 1 an, welcher eine größere Querabmessung hat, als der Längsabschnitt 18, sodass mittels des Längsabschnitts 18 und des Längsabschnitts 20 eine T-Form in einer flachen Erstreckung des Kontaktelements 1 gebildet ist.

An den Längsabschnitt 20 ist ein Längsabschnitt 22 angefügt, welcher eine kleinere Querabmessung aufweist als der Längsabschnitt 20. Der Längsabschnitt 22 ist an den Längsabschnitt 20 beispielsweise mittels Elektronenstrahlschweißens angefügt. Der Längsabschnitt 22 weist in diesem Ausführungsbeispiel eine kleinere Dickenabmessung auf, als die mit dem Längsabschnitt 20 verbundenen Teile des Kontaktelements 1. An den Längsabschnitt 22 schließt ein Längsabschnitt an, welcher einen Kontaktstift 24 zum Kontaktieren der Leiterplatte 38 bildet. Der Kontaktstift 24 weist einen sich zu einem Ende hin verjüngenden Endabschnitt 26 auf, welcher ein Einführen des Kontaktelements 1 in den Durchbruch der Leiterplatte 38 erleichtert. Eine Querabmessung des sich entlang der Längsachse 42 erstreckenden Stiftes 24 ist kleiner als eine Querabmessung des Längsabschnittes 22.

Das Kontaktelement 1 ist im Bereich des Längsabschnitts 18, des Längsabschnitts 20 und des Längsabschnitts 22 von einem elektrisch isolierenden Körper 28 umgeben und in den elektrisch isolierenden Körper 28 eingebettet. Der elektrisch isolierende Körper 28 weist einen sich parallel zu dem Längsabschnitt 22 erstreckenden Steg 29 auf, welcher an einem Ende des Stegs 29 einen Anschlag 30 zum Begrenzen eines Einführens des Stiftes 24 in die Leiterplatte 38 aufweist. Der elektrisch isolierende Körper 28 weist wenigstens eine sich quer zur Längsachse 42 erstreckende Einpressschulter auf. So kann das Kontaktelement 1 über die Einpressschulter mittels eines entsprechend ausgebildeten Werkzeugs mit der Leiterplatte 38 verbunden werden, wobei der Stift 24 des Kontaktelements 1 in den Durchbruch der Leiterplatte 38 eingepresst werden kann.

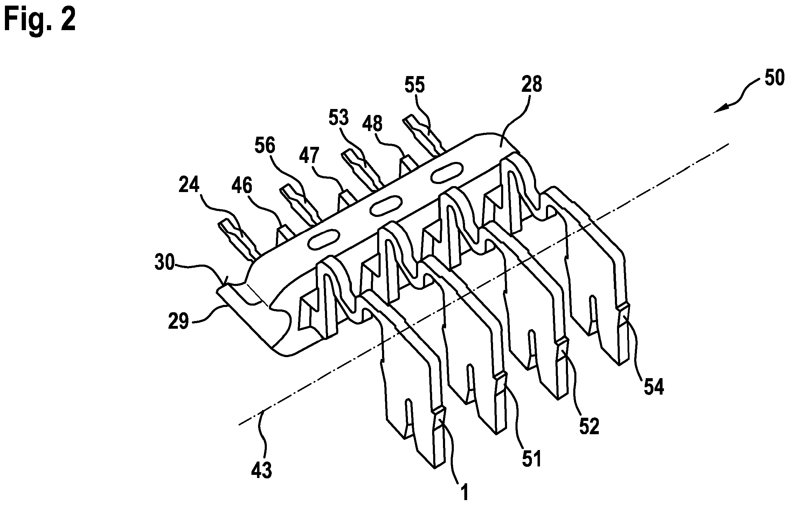

Figur 2 zeigt schematisch ein Ausführungsbeispiel für eine Kontaktreihe 50, wobei die Kontaktreihe 50 das in Figur 1 zuvor beschriebene Kontaktelement 1 und weitere Kontaktelemente 51, 52 und 54 umfasst. Die Kontaktreihe 50 umfasst in diesem Ausführungsbeispiel vier Kontaktelemente, denkbar ist auch eine Kontaktreihe 50 mit mehr als vier Kontaktelementen. Die Kontaktelemente 1, 51, 52 und 54 sind jeweils entlang einer Reihenachse 43 derart angeordnet, dass die Drahtaufnahmen, welche sich jeweils entlang der in Figur 1 dargestellten Querachse 40 erstrecken, zueinander gleich ausgerichtet sind und somit parallel zueinander verlaufen.

Die Kontaktelemente 1, 51, 52 und 54 sind gemeinsam und jeweils abschnittsweise in den in Figur 1 bereits in einer Schnittdarstellung dargestellten isolierenden Körper 28 eingebettet. Das Kontaktelement 1 weist im Bereich des von der Drahtaufnahme entgegengesetzten Endes den in Figur 1 zuvor beschriebenen Stift 24 auf. Das Kontaktelement 51 weist einen entsprechend dem Kontaktelement 1 angeordneten Stift 56, das Kontaktelement 52 einen entsprechend dem Stift 24 angeordneten Stift 53 und das Kontaktelement 54 einen entsprechend dem Stift 24 angeordneten Stift 55 auf. Die Kontaktreihe 50 kann über eine Einpressschulter, welche durch eine Seite des isolierenden Körpers 28 gebildet ist, mit einer Leiterplatte pressend verbunden werden. Zusätzlich zu dem in Figur 1 dargestellten Steg 29 weist der in Figur 2 dargestellte Körper 28 Stege 46, 47 und 48 auf, wobei der Steg 46 entlang der Achse 43 zwischen dem Stift 24 und dem Stift 56, der Steg 47 entlang der Achse 43 zwischen dem Steg 56 und dem Steg 53, und der Steg 48 entlang der Achse 43 zwischen dem Stift 53 und dem Stift 55 angeordnet ist. Die Stege 46, 47 und 48 erstrecken sich jeweils quer zur Achse 43 und parallel zur Kontaktelementlängsachse der Kontaktelemente. Die Kontaktelemente 1, 51, 52 und 54 sind in diesem Ausführungsbeispiel mit einer flachen Erstreckung zueinander parallel ausgerichtet.

Figur 3 zeigt den in Figur 1 bereits beschriebenen Gegenkontakt 9. Der Gegenkontakt 9 weist eine flache Erstreckung auf und ist beispielsweise aus einem Blech, insbesondere Kupferblech ausgestanzt. Der Gegenkontakt 9 weist in einer Aufsicht auf seine flache Erstreckung eine Großform einer eckigen Acht auf.

Der Gegenkontakt 9 weist zwei beispielsweise rechteckförmige Durchbrüche 68 und 69 auf, welche den in Figur 1 bereits beschriebenen Drahtabschnitt 10 zwischeneinander einschließen.

Das in Figur 1 bereits dargestellte Kontaktelement 1 kann den Gegenkontakt 9 derart kontaktieren, dass der Endabschnitt 32 in den Durchbruch 68 und der Endabschnitt 34 in den Durchbruch 69 eingreift. Dabei wird der Drahtabschnitt 10 in die Drahtaufnahme 5 wenigstens längsabschnittsweise eingeführt und elektrisch kontaktiert. Die Schneiden 7 und 8 können zum Unterstützen des elektrischen Kontaktierens in den Drahtabschnitt 10 einschneiden und so vorteilhaft eine Oxidschicht beim Kontaktieren durchbrechen.

Der Gegenkontakt 9 ist Bestandteil einer Gegenkontaktreihe 60, welche neben dem Gegenkontakt 9 noch entlang einer Längserstreckung 70, welche parallel oder koaxial zur Längserstreckung des Drahtabschnitts 10 verläuft, zueinander beabstandet angeordnete Gegenkontakte 62, 64 und 66 aufweist.

Die Gegenkontaktreihe 60 und die in Figur 2 dargestellte Kontaktreihe 50 können zusammen ein Verbindungssystem bilden. Dazu ist die Kontaktreihe 50 ausgebildet, mit der Gegenkontaktreihe 60 derart verbunden zu werden, dass ein Kontaktelement der Kontaktreihe 50 einen Gegenkontakt der Gegenkontaktreihe 60 elektrisch kontaktiert, wobei die Drahtaufnahmen der Kontaktelemente der Kontaktreihe 50 jeweils einen entsprechenden Drahtabschnitt des entsprechenden Gegenkontakts der Gegenkontaktreihe 60 aufnehmen und elektrisch kontaktieren können. Die Gegenkontakte 9, 62, 64 und 66 sind gemeinsam jeweils abschnittsweise in einen ringförmigen elektrisch isolierenden Körper 72, beispielsweise einen Kunststoffkörper 72 eingebettet. Der Gegenkontakt 62 weist einen Kontaktdraht 63, der Gegenkontakt 64 einen Kontaktdraht 65 und der Gegenkontakt 66 einen Kontaktdraht 67 auf. Die Kontaktdrähte der Gegenkontakte sind jeweils zum Kontaktiertwerden durch eine entsprechende Drahtaufnahme, beispielsweise jeweils eine der in Figur 1 dargestellten Drahtaufnahmen der Kontaktelemente der Kontaktreihe ausgebildet.

## Patentansprüche

1. Elektrisch leitfähiges Kontaktelement (1, 51, 52, 54), zum Verbinden eines Kontaktdrahtes (10, 63, 65, 67) mit einer Leiterplatte (38), wobei das Kontaktelement (1, 51, 52, 54) einen Stift (24, 53, 55, 56) aufweist, welcher ausgebildet ist, in die Leiterplatte (38) eingepresst zu werden, und das Kontaktelement (1, 51, 52, 54) eine Drahtaufnahme (5) aufweist, welche ausgebildet ist, einen Längsabschnitt des Kontaktdrahtes (10, 63, 65, 67) während eines Einführens in die Drahtaufnahme (5) einschneidend und/oder einpressend zu kontaktieren und festzuhalten,
**dadurch gekennzeichnet, dass**
die Drahtaufnahme (5) ausgebildet ist, den Kontaktdraht (10, 63, 65, 67) in einer Querachse (40) aufzunehmen und zu kontaktieren, die mit wenigstens einer Querkomponente oder quer zu einer Stiftlängsachse (42) des Stifts (24, 53, 55, 56) verläuft, wobei ein elektrisch leitfähiger Teil des Kontaktelements (1, 51, 52, 54) wenigstens zwei Kontaktabschnitte (18, 22) mit zueinander verschiedenen Materialeigenschaften aufweist, wobei das Kontaktelement (1, 51, 52, 54) einen den Stift (24, 53, 55, 56) umfassenden Kontaktabschnitt (22) aufweist und einen mit dem den Stift (24, 53, 55, 56) umfassenden Kontaktabschnitt verbundenen, die Drahtaufnahme (5) umfassenden Kontaktabschnitt (32, 34) aufweist, wobei der den Stift (24, 53, 55, 56) umfassende Kontaktabschnitt (22) aus einem steiferen und härteren Material gebildet ist als der die Drahtaufnahme (5) umfassende Kontaktabschnitt (32, 34).

2. Kontaktelement (1, 51, 52, 54) nach Anspruch 1,
**dadurch gekennzeichnet, dass**
die Materialeigenschaft eine Mohs-Härte ist.

3. Kontaktelement (1, 51, 52, 54) nach Anspruch 1 oder 2,
**dadurch gekennzeichnet, dass**
die Kontaktabschnitte (18,22) jeweils aus einem Blech gebildet sind, wobei der den Stift (24, 53, 55, 56) umfassende Kontaktabschnitt (22) aus einem dünneren Blech gebildet ist als der die Drahtaufnahme (5) umfassende Kontaktabschnitt (32, 34).

4. Kontaktelement (1, 51, 52, 54) nach Anspruch 3,
**dadurch gekennzeichnet, dass**
die Blechdicke im Bereich des Stiftes weniger oder gleich 0,6 Millimeter beträgt, und die Blechdicke im Bereich der Drahtaufnahme wenigstens 0,8 Millimeter, oder genau 0,8 Millimeter beträgt.

5. Kontaktelement (1, 51, 52, 54) nach einem der vorhergehenden Ansprüche, **dadurch gekennzeichnet, dass**
die wenigstens zwei Kontaktabschnitte (18, 22) mittels Elektronenstrahlschweißen miteinander verbunden sind.

6. Kontaktelement (1, 51, 52, 54) nach einem der vorhergehenden Ansprüche, **dadurch gekennzeichnet, dass**
zwischen der Drahtaufnahme (5) und dem Stift (24, 53, 55, 56) ein elektrisch leitfähiger Entlastungsbereich (12, 14) gebildet ist, so dass eine Bewegung des Stiftes (24, 53, 55, 56) vermindert auf die Drahtaufnahme übertragen werden kann.

7. Kontaktelement (1, 51, 52, 54) nach Anspruch 6,
**dadurch gekennzeichnet, dass**
der Entlastungsbereich (12, 14) durch wenigstens eine elektrisch leitfähige Mäanderschleife (12, 14) gebildet ist.

8. Kontaktelement (1, 51, 52, 54) nach einem der vorhergehenden Ansprüche, **dadurch gekennzeichnet, dass**
das Kontaktelement (1, 51, 52, 54) wenigstens abschnittsweise in einen elektrisch isolierenden Körper (28) eingebettet ist.

9. Kontaktreihe (50) umfassend wenigstens zwei oder mehreren Kontaktelementen (1, 51, 52, 54) nach einem der vorhergehenden Ansprüche,
**dadurch gekennzeichnet, dass**
die wenigstens zwei oder mehreren Kontaktelemente (1, 51, 52, 54) jeweils wenigstens abschnittsweise gemeinsam in einen elektrisch isolierenden Körper (28) eingebettet sind, wobei die Drahtaufnahmen (5) der Kontaktelemente jeweils in eine gemeinsame Richtung weisen.

10. Verbindungssystem umfassend wenigstens ein Kontaktelement (1) gemäß einem der vorhergehenden Ansprüche 1 bis 6 und wenigstens einen Gegenkontakt (9, 62, 64, 66), wobei der Gegenkontakt (9) ein einer flachen Erstreckung als flache Acht ausgebildet ist und den Kontaktdraht (10, 63, 65, 67) aufweist, wobei der Gegenkontakt (9) aus einem Blech gestanzt ist und zwei Durchbrüche (68, 69) aufweist, die den Kontaktdraht (10) zwischeneinander einschließen.

11. Verbindungssystem nach Anspruch 10,
**dadurch gekennzeichnet, dass**
der Gegenkontakt (9, 62, 64, 66) durch eine Stanzgitter aus Kupfer gebildet ist, wobei die Durchbrüche jeweils rechteckförmig ausgebildet sind und der Gegenkontakt (9) in einer Aufsicht auf seine flache Erstreckung eine eckige Acht bildet, wobei der Kontaktdraht (10, 63, 65, 67) einen mittleren Balken der eckigen Acht bildet.

12. Verbindungssystem umfassend wenigstens eine Kontaktreihe (50) gemäß Anspruch 9 und wenigstens eine Gegenkontaktreihe (60), wobei die Gegenkontaktreihe (60) zu den Kontaktelementen der Kontaktreihe entsprechende Gegenkontakte (9, 62, 64, 66) aufweist, wobei die Gegenkontakte gemeinsam in einen elektrisch isolierenden Körper (72) eingebettet sind.

## Claims

1. Electrically conductive contact element (1, 51, 52, 54) for connecting a contact wire (10, 63, 65, 67) to a printed circuit board (38), wherein the contact element (1, 51, 52, 54) has a pin (24, 53, 55, 56) which is designed to be pressed into the printed circuit board (38), and the contact element (1, 51, 52, 54) has a wire receptacle (5) which is designed to make contact with and to securely hold a longitudinal section of the contact wire (10, 63, 65, 67) in a cutting-in and/or pressing-in manner during insertion into the wire receptacle (5), **characterized in that**
the wire receptacle (5) is designed to receive and to make contact with the contact wire (10, 63, 65, 67) in a transverse axis (40) which runs with at least one transverse component or transversely to a pin longitudinal axis (42) of the pin (24, 53, 55, 56), wherein an electrically conductive portion of the contact element (1, 51, 52, 54) has at least two contact sections (18, 22) with different material properties to one another, wherein the contact element (1, 51, 52, 54) has a contact section (22) comprising the pin (24, 53, 55, 56) and has a contact section (32, 34) connected to the contact section comprising the pin (24, 53, 55, 56) and comprising the wire receptacle (5), wherein the contact section (22) comprising the pin (24, 53, 55, 56) is formed from a stiffer and harder material than the contact section (32, 34) comprising the wire receptacle (5).

2. Contact element (1, 51, 52, 54) according to Claim 1,
**characterized in that**
the material property is a Mohs hardness.

3. Contact element (1, 51, 52, 54) according to Claim 1 or 2,
**characterized in that**
the contact sections (18, 22) are each formed from a metal sheet, wherein the contact section (22) comprising the pin (24, 53, 55, 56) is formed from a thinner metal sheet than the contact section (32, 34) comprising the wire receptacle (5).

4. Contact element (1, 51, 52, 54) according to Claim 3,
**characterized in that**
the metal sheet thickness in the region of the pin is less than or equal to 0.6 millimetres, and the metal sheet thickness in the region of the wire receptacle is at least 0.8 millimetres, or precisely 0.8 millimetres.

5. Contact element (1, 51, 52, 54) according to one of the preceding claims,
**characterized in that**
the at least two contact sections (18, 22) are connected to one another by means of electron beam welding.

6. Contact element (1, 51, 52, 54) according to one of the preceding claims,
**characterized in that**
an electrically conductive relief region (12, 14) is formed between the wire receptacle (5) and the pin (24, 53, 55, 56), so that a movement of the pin (24, 53, 55, 56) can be transmitted to the wire receptacle in a reduced manner.

7. Contact element (1, 51, 52, 54) according to Claim 6,
**characterized in that**
the relief region (12, 14) is formed by at least one electrically conductive meandering loop (12, 14).

8. Contact element (1, 51, 52, 54) according to one of the preceding claims,
**characterized in that**
the contact element (1, 51, 52, 54) is embedded in an electrically insulating body (28) at least in sections.

9. Contact row (50) comprising at least two or more contact elements (1, 51, 52, 54) according to one of the preceding claims,
**characterized in that**
the at least two or more contact elements (1, 51, 52, 54) are each embedded in an electrically insulating body (28) together at least in sections, wherein the wire receptacles (5) of the contact elements each point in a common direction.

10. Connecting system comprising at least one contact element (1) according to one of the preceding Claims 1 to 6 and at least one mating contact (9, 62, 64, 66), wherein the mating contact (9) in a flat extent is designed as a flat eight and has the contact wire (10, 63, 65, 67), wherein the mating contact (9) is punched out of a metal sheet and has two apertures (68, 69) which enclose the contact wire (10) between one another.

11. Connecting system according to Claim 10, **characterized in that**
the mating contact (9, 62, 64, 66) is formed by a leadframe composed of copper, wherein the apertures are each of rectangular design and the mating contact (9) forms an angular eight in a plan view of its flat extent, wherein the contact wire (10, 63, 65, 67) forms a central bar of the angular eight.

12. Connecting system comprising at least one contact row (50) according to Claim 9 and at least one mating contact row (60), wherein the mating contact row (60) has mating contacts (9, 62, 64, 66) which correspond to the contact elements of the contact row, wherein the mating contacts are embedded in an electrically insulating body (72) together.

## Revendications

1. Elément de contact électriquement conducteur (1, 51, 52, 54) permettant de relier un fil de contact (10, 63, 65, 67) à une carte de circuits imprimés (38), l'élément de contact (1, 51, 52, 54) présentant une broche (24, 53, 55, 56) qui est réalisée pour être enfoncée dans la carte de circuits imprimés (38), et l'élément de contact (1, 51, 52, 54) présentant un logement de fil (5) qui est réalisé pour mettre en contact par incision et/ou enfoncement et retenir une partie longitudinale du fil de contact (10, 63, 65, 67) pendant une introduction dans le logement de fil (5), **caractérisé en ce que** le logement de fil (5) est réalisé pour recevoir et mettre en contact le fil de contact (10, 63, 65, 67) dans un axe transversal (40) qui s'étend par au moins une composante transversale ou transversalement à un axe longitudinal de broche (42) de la broche (24, 53, 55, 56), une partie électriquement conductrice de l'élément de contact (1, 51, 52, 54) présentant au moins deux parties de contact (18, 22) ayant des propriétés matérielles différentes l'une de l'autre, l'élément de contact (1, 51, 52, 54) présentant une partie de contact (22) comprenant la broche (24, 53, 55, 56), et présentant une partie de contact (32, 34) reliée à la partie de contact comprenant la broche (24, 53, 55, 56) et comprenant le logement de fil (5), la partie de contact (22) comprenant la broche (24, 53, 55, 56) étant formée en un matériau plus rigide et plus dur que la partie de contact (32, 34) comprenant le logement de fil (5).

2. Elément de contact (1, 51, 52, 54) selon la revendication 1, **caractérisé en ce que** la propriété matérielle est une dureté de Mohs.

3. Elément de contact (1, 51, 52, 54) selon la revendication 1 ou 2, **caractérisé en ce que** les parties de contact (18, 22) sont formées respectivement à partir d'une tôle, la partie de contact (22) comprenant la broche (24, 53, 55, 56) étant formée à partir d'une tôle plus fine que la partie de contact (32, 34) comprenant le logement de fil (5).

4. Elément de contact (1, 51, 52, 54) selon la revendication 3, **caractérisé en ce que** l'épaisseur de tôle au niveau de broche est inférieure ou égale à 0,6 millimètres, et l'épaisseur de tôle au niveau du logement de fil est au moins égale à 0,8 millimètre ou exactement égale à 0,8 millimètres.

5. Elément de contact (1, 51, 52, 54) selon l'une quelconque des revendications précédentes, **caractérisé en ce que** les au moins deux parties de contact (18, 22) sont reliées au moyen d'un soudage par faisceau d'électrons.

6. Elément de contact (1, 51, 52, 54) selon l'une quelconque des revendications précédentes, **caractérisé en ce qu'**une zone de décharge (12, 14) électriquement conductrice est formée entre le logement de fil (5) et la broche (24, 53, 55, 56) de sorte qu'un mouvement de la broche (24, 53, 55, 56) peut être transmis au logement de fil de manière atténuée.

7. Elément de contact (1, 51, 52, 54) selon la revendication 6, **caractérisé en ce que** la zone de décharge (12, 14) est formée par au moins une boucle de méandre (12, 14) électriquement conductrice.

8. Elément de contact (1, 51, 52, 54) selon l'une quelconque des revendications précédentes, **caractérisé en ce que** l'élément de contact (1, 51, 52, 54) est incorporé au moins par endroits dans un corps (28) électriquement isolant.

9. Rangée de contacts (50), comprenant au moins deux ou plusieurs éléments de contact (1, 51, 52, 54) selon l'une quelconque des revendications précédentes, **caractérisée en ce que** les au moins deux ou plusieurs éléments de contact (1, 51, 52, 54) sont incorporés respectivement au moins par endroits ensemble dans un corps (28) électriquement isolant, les logements de fil (5) des éléments de contact étant respectivement tournés dans une direction commune.

10. Système de connexion, comprenant au moins un élément de contact (1) selon l'une quelconque des revendications précédentes 1 à 6 et au moins un contact complémentaire (9, 62, 64, 66), dans lequel le contact complémentaire (9) est réalisé en formant un huit plan dans une étendue plane et présente le fil de contact (10, 63, 65, 67), le contact complémentaire (9) étant découpé dans une tôle et présentant deux passages (68, 69) qui enferment le fil de contact (10) entre eux.

11. Système de connexion selon la revendication 10, **caractérisé en ce que** le contact complémentaire (9, 62, 64, 66) est formé par un grillage estampé en cuivre, les passages étant respectivement réalisés en forme de rectangle, et le contact complémentaire (9) formant dans une vue sur son étendue plane un huit angulaire, le fil de contact (10, 63, 65, 67) formant une barre centrale du huit angulaire.

12. Système de connexion, comprenant au moins une rangée de contacts (50) selon la revendication 9 et au moins une rangée de contacts complémentaires (60), la rangée de contacts complémentaires (60) présentant des contacts complémentaires (9, 62, 64, 66) correspondants aux éléments de contact de la rangée de contact, les contacts complémentaires étant incorporés ensemble dans un corps (72) électriquement isolant.
